# EUROPEAN PATENT SPECIFICATION

(11) **EP 1 253 814 B1**
(45) Date of publication and mention of the grant of the patent: **30.05.2007**
(21) Application number: 02100378.5
(22) Date of filing: 16.04.2002
(51) Int. Cl.: H05K 7/02, B60R 16/02, H05K 1/02

(54) **Heat insulation structure of electric junction box**
Struktur eines elektrischen Anschlusskastens mit Wärmeschutz
Structure de boîte de raccordement électrique isolée thermiquement

(30) Priority: 27.04.2001 JP 2001132767
(43) Date of publication of application: 30.10.2002
(73) Proprietor: YAZAKI CORPORATION, Minato-ku Tokyo 108-8333 (JP)
(72) Inventor: Takahara, Yoshiyuki, Shizuoka (JP)
(74) Representative: Brunner, Michael John

(56) References cited:
- EP-A- 0 816 177
- DE-A- 4 121 545
- DE-A- 4 436 547

## Description

The present invention relates to a heat insulation structure of an electric junction box, as well as to a heat insulation structure for protecting control components from heat-generating components in an electric junction box which houses the control components and the heat-generating components mounted on a board.

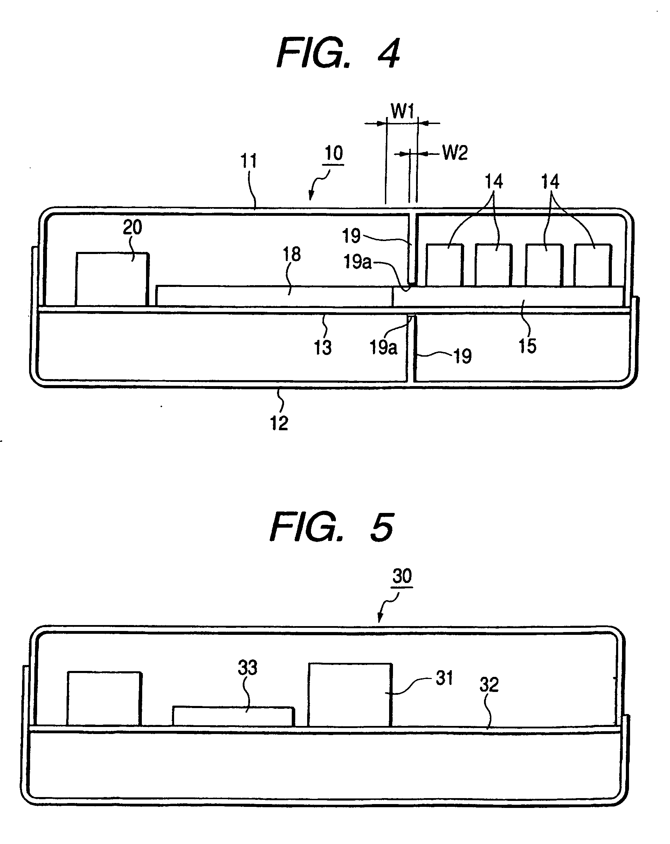

In an electric junction box, adverse thermal effect on control components has hitherto been avoided by means of avoiding the placement of heat-generating components, such as normally-energized relays, on a printed circuit board (PCB) (hereinafter called a "board").
However, in accordance with a recent increase in the number of electric control units (ECU) to be provided in a vehicle, further space saving is required. As shown in Fig. 5, an attempt is made to realize space saving by incorporating a relay 31, which is a heat-generating component, into an electric junction box 30 of an ECU and mounting the same on a board 32.

In the related art electric junction box 30 shown in Fig. 5, the heat generated by the relay 31 is transferred to a CPU 33, which is a control component, by way of a Cu trace laid on the board 32. As a result, the temperature of the CPU 33 increases. Particularly, an ECU mounted in an engine compartment involves a risk of the CPU 33 being subjected to a temperature higher than a guaranteed temperature.
A conceivable countermeasure against this problem is use of a component having a high guaranteed temperature as the CPU 33. In this case, the cost of the CPU is greatly increased.
DE 4436547A discloses a housing for electronic components in which heat sensitive components are protected from heat generating components.
The present invention aims at providing a heat insulation structure of an electric junction box which enables mounting of a control component and a heat-generating component on a single substrate while avoiding adverse thermal effects on the control component from the heat-generating component at low cost, and which enables space savings by means of incorporating the heat-generating component into the electric junction box.
DE 4121545A discloses a heat insulation structure comprising:
an electric junction box constituted by upper and lower covers; and
a board housed in the electric junction box, including,
a control section on which a control component is mounted,
a mounting section on which a plurality of heat-generating components are mounted, and
a heat conduction prevention section defined between the control section and the mounting section;

The present invention is characterised in that:
the heat conduction prevention section is provided with only a wiring assembly; and that
the upper and lower covers are each provided with convection-of-air prevention walls brought into contact with the heat conduction prevention section (A), so that the convection-of-air prevention walls prevent convention of air across the conduction prevention section.

The plurality of heat-generating components may be relays. The relays may be mounted on the mounting section through a relay block.
The width of the conduction prevention section, in a direction perpendicular to the direction of connecting the conduction prevention section with the mounting section, may be smaller than the width of the mounting section.

In the heat insulation structure of the electric junction box, conduction, to the control component, of the heat developed by the heat-generating components provided on the same board as that on which the control component is mounted is minimized by means of mounting the plurality of heat-generating components on the board on the mounting section and defining a conduction prevention section between the control component and the heat-generating components on the board.
By means of the heat insulation structure of the electric junction box having the foregoing structure, the convection-of-air prevention wall brought into contact with the conduction prevention section on the board inhibits convection of air across the conduction prevention section within the electric junction box.
As a result, heat transfer due to convection of air from the heat-generating components to the control component in the electric junction box is inhibited.
In the accompanying drawings:
Fig. 1 is a perspective view showing a board of which a heat insulation structure of an electric junction box according to an embodiment of the invention;
Fig. 2 is a plan view showing only the board shown in Fig. 1;
Fig. 3 is a perspective view of a relay block shown in Fig. 2 when viewed from the back;
Fig. 4 is a substantially-longitudinal cross-sectional view showing the electric junction box having the board shown in Fig. 1 incorporated therein; and
Fig. 5 is a substantially-longitudinal cross-sectional view showing a related art electric junction box.

An embodiment of the invention will be described in detail hereinbelow by reference to the accompanying drawings.

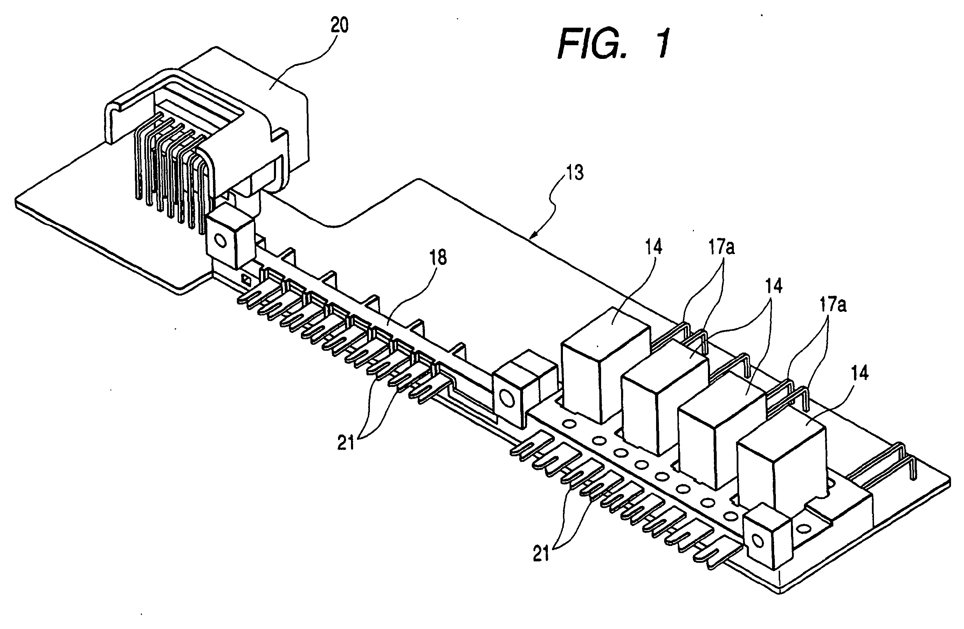

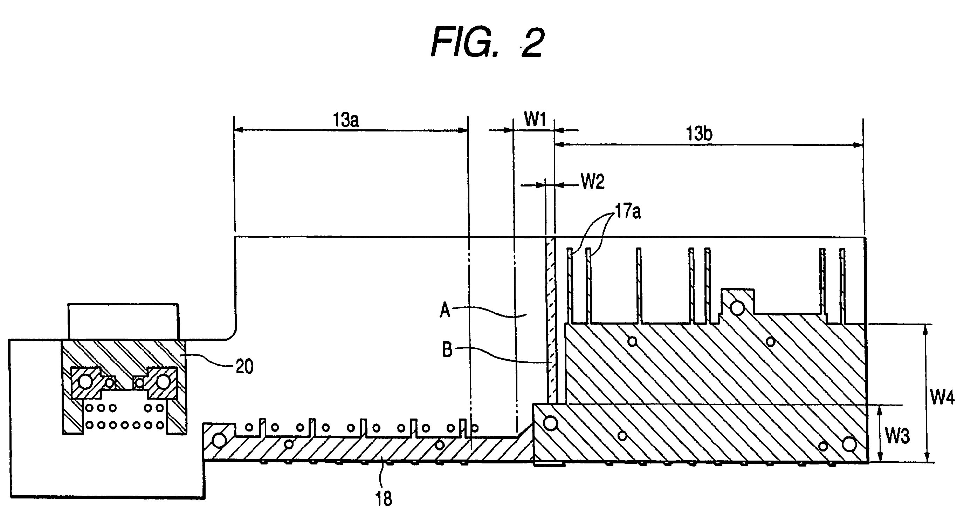

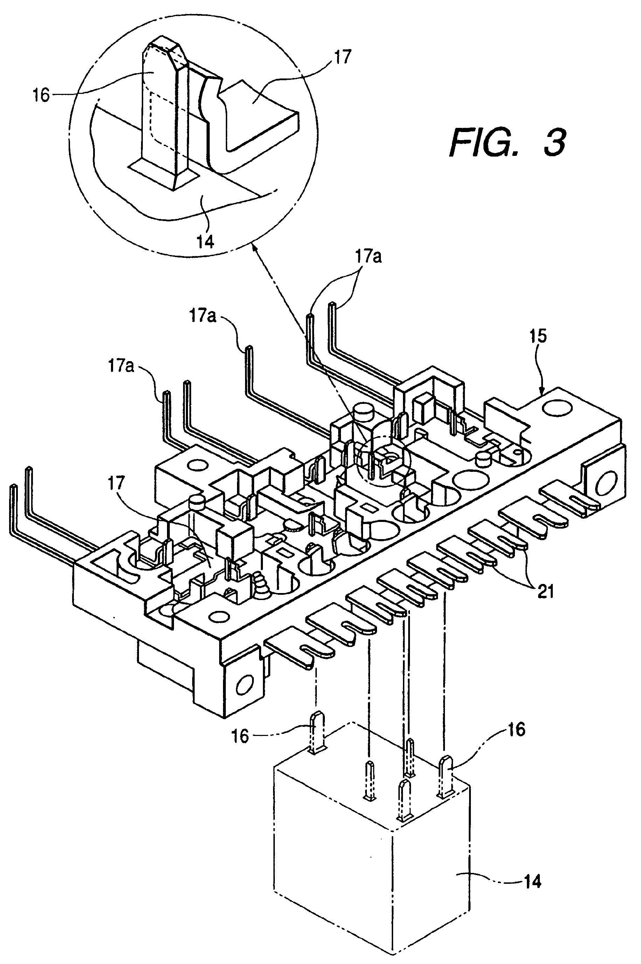

Fig. 1 is a perspective view showing a board to which a heat insulation structure of an electric junctionbox according to one embodiment of the invention is applied; and Fig. 2 is a plan view showing only the board shown in Fig. 1. Fig. 3 is a perspective view showing a relay box shown in Fig. 2 from its back side; and Fig. 4 is a substantially-longitudinal cross-sectional view showing the electric junction box having the substrate shown in Fig. 1 incorporated therein.

In the drawings, an electric junction box 10 comprises an upper cover 11 and a lower cover 12. A control component (not shown), such as a CPU, and heat-generating components such as relays 14, which are to be mounted on a board 13 such as a PCB, are housed within an internal space defined between the upper cover 11 and the lower cover 12.

The plurality of relays 14 are mounted on the board 13 through a relay block 15, and the heat generated by the relays 14 is not conducted directly to the board 13.
A relay terminal 16 of each relay 14 is connected to a bus bar 17 provided in the relay block 15, by means of fusing or hot-soldering. Relay coils are connected to the board 13 by way of a bus bar extension 17a which extends from the bus bar 17 substantially in the form of the letter L.
A width W3 of the conduction prevention section in a direction perpendicular to a direction of connecting the conduction prevention section with the mounting section is smaller than a width W4 of the mounting section, so that the heat generated by the relays 14 on the mounting section 13b is difficult to be conducted to the control section 13a.

A strip-shaped conduction prevention section A having a predetermined width W1 is provided in the board 13, between a control section 13a into which a control part is to be mounted and the relay mounting section 13b. No Cu trace is provided in the conduction prevention section A, and only a wiring assembly (i.e. , a signal line) 18 is provided in the conduction prevention section A.

The conduction prevention section A minimizes heat conduction which arises in the Cu trace and reduces conduction of heat from the relays 14 to the control component to a minimum.

A convection-of-air prevention wall 19 is provided integrally on an interior surface of the upper cover 11 of the electric junction box 10, and another convection-of-air prevention wall 19 is provided integrally on an interior surface of the lower cover 12 of the same, in which the walls 19 vertically pair up with each other with the board 13 sandwiched therebetween, as shown in Fig. 4. Distal ends 19a of the respective convection-of-air prevention walls 19 are brought into contact with a mount inhibition area B having a predetermined with W2 within the conduction prevention section A of the board 13, thereby preventing occurrence of convection of air across the conduction prevention section A in the electric junction box 10.
In the drawing, reference numeral 20 designates a signal connector; and 21 designates a wiring terminal to be brought into contact with an electric wire (not shown).

The operation of the heat insulation structure according to the embodiment will now be described.
Conduction, to the control component, of heat generated by the relays 14 mounted on the single board 13 which is the same board on which the control component is mounted is minimized by mounting the relays 14 on the board 13 through the relay block 15 and defining the conduction prevention section A on the board 13.
Namely, presence of the conduction prevention section A on the board 13 inhibits conduction of the heat generated by the relays 14 to the control component through a Cu trace on the board 13.

In the electric junction box 10, the convection-of-air prevention walls 19 brought in contact with the conduction prevention section A on the board 13 inhibit occurrence of convection of air across the conduction prevention section A from the relays 14 to the control component (i.e., from the right side to the left side in Fig. 2).
As a result, heat transfer due to convection of air in the electric junction box 10 is inhibited.

According to the embodiment, heat-generating components such as the relays 14 are mounted on the board 13 through the relay block 15, and the conduction prevention section A is provided on the board 13, between the control component and the relays 14.
Further, the convection-of-air prevention wall 19 is provided on the interior surface of the upper cover 11 constituting the electric junction box 10 while being brought in contact with the mount inhibition area B within the conduction prevention section A on the board 13.

Accordingly, adverse thermal effect on the control component due to the heat generated by the relays 14 can be avoided at low cost. In this way, the control component and the relays 14 can be mounted on the single board 13 without involvement of a heat problem.
As a result, an attempt can be made to realize space savings by means of incorporating the heat-generating components 14 into the electric junction box 10, thereby enabling incorporation of the relays 14 into, e.g., an ECU to be mounted in an engine compartment.

The present invention is not limited to the embodiment set forth and is susceptible to modification or alterations, as required. The material, geometry, dimensions, patterns, number, and locations of the heat-generating components, those of the substrate, those of the conduction prevention section, those of the upper cover, those of the lower cover, and those of the convection-of-air prevention walls described in the embodiment can be set arbitrarily and are not limited.

According to the invention, heat-generating components are mounted on a board while being grouped into a plurality of blocks. A conduction prevention section is defined between a control component and heat-generating components, which are to be mounted on a board. Hence, adverse affect on the control component due to the heat developing in the heat-generating components is avoided by employment of a low-cost structure, and the control component and the heat-generating components can be mounted on the single board.
As a result, space savings can be realized by means of incorporating the heat-generating components into the electric junction box.

Further, according to the invention, heat-generating components are mounted on a board while being grouped into a plurality of blocks . A conduction prevention section is defined between a control component and heat-generating components, which are to be mounted on a board. Convection-of-air prevention walls brought in contact with the conduction prevention section on the board prevent occurrence of convection of air across the conduction prevention section within the electric junction box.
Accordingly, adverse affect on the control component due to the heat developing in the heat-generating components is avoided by employment of a low-cost structure, and the control component and the heat-generating components can be mounted on the single board. As a result, space savings can be realized by means of incorporating the heat-generating components into the electric junction box.

## Claims

1. A heat insulation structure comprising:
an electric junction box (10); constituted by upper (11) and lower (12) covers; and
a board (13) housed in the electric junction box (10), including,
a control section (13a) on which a control component is mounted,
a mounting section on which a plurality of heat-generating components (14) are mounted, and
a heat conduction prevention section (A) defined between the control section (13a) and the mounting section; and **characterised in that**:
the heat conduction prevention section (A) is provided with only a wiring assembly (18); and that
the upper (11) and lower (12) covers are each provided with convection-of-air prevention walls (19) brought into contact with the heat conduction prevention section (A), so that the convection-of-air prevention walls prevent convection of air across the heat conduction prevention section (A).

2. The heat insulation structure according to claim 1, wherein the plurality of heat-generating components (14) are relays.

3. The heat insulation structure according to claim 2, wherein the relays (14) are mounted on the mounting section through a relay block (15).

4. The heat insulation structure according to claim 1, wherein the width (W3) of the conduction prevention section (A), in a direction perpendicular to the direction of connecting the conduction prevention section with the mounting section, is smaller than the width (W4) of the mounting section.

## Patentansprüche

1. Wärmeisolierende Struktur umfassend:
einen elektrischen Anschlusskasten (10), bestehend aus einer oberen Abdeckung (11) und einer unteren Abdeckung (12), und
eine in dem elektrischen Anschlusskasten (10) aufgenommene Leiterplatte (13), aufweisend
einen Steuerabschnitt (13a), an dem eine Steuerkomponente montiert ist,
einen Montageabschnitt, an dem eine Mehrzahl von Wärme erzeugenden Komponenten montiert ist, und
einen Wärmeisolierabschnitt (A), der zwischen dem Steuerabschnitt (13a) und dem Montageabschnitt gebildet ist, und
**dadurch gekennzeichnet, dass** der Wärmeisolierabschnitt (A) nur mit einer Verdrahtungsordnung (18) versehen ist, und dass
die obere (11) und untere (12) Abdeckung jeweils mit Luftkonvektionsverhinderungswänden (19) ausgestattet sind, die mit dem Wärmeisolierabschnitt (A) so in Kontakt gebracht sind, dass die Luftkonvektionsverhinderungswände eine Luftkonvektion über den Wärmeisolierabschnitt (A) hinweg verhindern.

2. Wärmeisolierende Struktur nach Anspruch 1,
wobei die Mehrzahl der Wärme erzeugenden Komponenten (14) Relais sind.

3. Wärmeisolierende Struktur nach Anspruch 2,
wobei die Relais (14) über einen Relaisblock (15) auf dem Montageabschnitt installiert sind.

4. Wärmeisolierende Struktur nach Anspruch 1,
wobei die Dicke (W3) des Isolierabschnitts (A) in einer Richtung senkrecht zur Verbindungsrichtung des Isolierabschnitts mit dem Montageabschnitt kleiner ist als die Dicke (W4) des Montageabschnitts.

## Revendications

1. Structure d'isolation thermique comprenant :
une boîte de jonction électrique (10), constituée par des couvercles supérieur (11) et inférieur (12) ; et
une planchette (13) logée dans la boîte de jonction électrique (10), comprenant :
une section de commande (13a) sur laquelle on monte un composant de commande,
une section de montage sur laquelle on monte une pluralité de composants de génération de chaleur (14), et
une section de prévention de conduction de chaleur (A) définie entre la section de commande (13a) et la section de montage ; et **caractérisée en ce que** :
la section de prévention de conduction de chaleur (A) est prévue avec uniquement un ensemble de câblage (18) ; et **en ce que**
les couvercles supérieur (11) et inférieur (12) sont chacun prévus avec des parois de prévention de convection d'air (19) amenés en contact avec la section de prévention de conduction de chaleur (A), de sorte que les parois de prévention de convection d'air empêchent la convection de l'air sur la section de prévention de conduction de chaleur (A).

2. Structure d'isolation thermique selon la revendication 1, dans laquelle la pluralité de composants de génération de chaleur (14) sont des relais.

3. Structure d'isolation thermique selon la revendication 2, dans laquelle les relais (14) sont montés sur la section de montage par l'intermédiaire d'un bloc de relais (15).

4. Structure d'isolation thermique selon la revendication 1, dans laquelle la largeur (W3) de la section de prévention de conduction (A), dans une direction perpendiculaire à la direction du raccordement de la section de prévention de conduction avec la section de montage, est inférieure à la largeur (W4) de la section de montage.
